# EUROPEAN PATENT APPLICATION

(11) **EP 4 279 889 A1**
(43) Date of publication of application: **22.11.2023**
(21) Application number: 22305730.8
(22) Date of filing: 17.05.2022
(51) Int. Cl.: G01K 7/42, H01L 23/473, H03K 17/082

(54) **IMPROVED POWER COMPONENT FOR ELECTRIC OR HYBRID AIRCRAFT**

(71) Applicant: Airbus SAS, 31700 Blagnac (FR)
(72) Inventor: STEINER, Gerhard, 82024 Taufkirchen (DE); KAPAUN, Florian, 82024 Taufkirchen (DE); YBANEZ, Ludovic, 31700 Blagnac (FR); SURAPANENI, Ravi Kiran, 31700 Blagnac (FR); GALLA, Gowtham, 31700 Blagnac (FR)
(74) Representative: Cabinet Le Guen Maillet

(57) **Abstract**

The invention relates to an electronic circuit (100) comprising a power transistor (110) of the MOSFET type comprising a gate (112) connected to a control circuit (140) of said gate (112), the electronic circuit (100) being configured with:
- said control circuit (140) of said gate (112) being configured to operate at a temperature called ambient temperature, non-cryogenic, and,
- said power transistor (110) as well as an interfacing circuit (130) connected between said gate (112) and said control circuit (140) being configured to operate at a cryogenic temperature, each of the components of said interfacing circuit (130) being established at a maximum distance (L) from the power transistor,
the electronic circuit (100) further comprising at least one measurement signal (150b) connected between the interfacing circuit (130) operating at a cryogenic temperature and the control circuit (140) operating at ambient temperature, to make it possible to enslave the operation of the power transistor (110) with respect to a supervised operating parameter.

## Description

### TECHNICAL FIELD

The present invention relates to electronic circuit comprising passive electronic components and electronic components of the integrated circuit type. The invention relates more particularly to power electronic systems and in particular those used in on board systems of an aircraft.

### RELATED ART

Liquid hydrogen is a cryogenic fluid that can be used as an energy source for electricity generation. Thus, for example, it is possible to use a hydrogen fuel cell to power all the flight control and communication systems of an aircraft, as well as the on-board lighting and the power supply of various accessory devices used in the aircraft. Liquid hydrogen can also be used as an energy source for the propulsion of an aircraft, by powering a fuel cell or by direct combustion, which has the advantage of only releasing water into the atmosphere. The use of hydrogen requires distribution systems between one or more production or storage tanks and consuming devices. Thus, pipes are conventionally used to convey liquid hydrogen between a storage tank and a liquid hydrogen consuming device such as, for example, a hydrogen fuel cell.

It is known that there is a need to massively reduce the production of carbon emissions, to safeguard the environment, and electric or hybrid propulsion is showing promise for this. But the conventional systems on board of an aircraft are such that the weight/electrical power ratio is not satisfactory as they are and there is therefore a need to obtain electrical systems making it possible to provide power in relation to their weight to satisfy all the constraints.

It is therefore necessary to optimize the weight/electrical power ratio of all the elements of an aircraft propulsion system, and in particular the power components through which strong currents pass.

One way to improve the efficiency of power components is to use the power components in a cryogenic temperature environment, which greatly reduces resistance and thus Joule losses, and then correspondingly increases efficiency, while placing the control circuit(s) of the power components at an ambient temperature environment. But standard control circuits, such as power transistor gate control ICs ("Integrated Circuits"), are not suitable for such a configuration. Indeed, power components operating in a cryogenic environment have characteristics that may vary significantly from one to another or as a function of the environment. Some characteristics that can be varied are for example a saturation level, an on-state resistance, a threshold level.

The situation can be improved.

### SUMMARY OF THE INVENTION

The purpose of the invention is to provide an optimized power electronic circuit for which the efficiency is increased thanks to the use of a power component at a cryogenic temperature while limiting the complexity of implementation and the cost of the circuit with a control circuit operating at room temperature, and while making it possible to control the operation of the power electronic circuit as a function of one or more determined operating conditions.

To this end, it is proposed an electronic circuit comprising a power transistor comprising a gate connected to a control circuit of said gate, the electronic circuit being configured with:
- said control circuit of said gate being configured to operate at a temperature called ambient temperature, non-cryogenic, and,
- said power transistor as well as an interfacing circuit connected between said gate and said control circuit being configured to operate at a cryogenic temperature, each of the components of said interfacing circuit being established at a maximum predetermined distance from the power transistor, and,
characterized in that the electronic circuit comprises measurement means configured to measure at least one measurement signal, the measurement means being connected between the interfacing circuit operating at a cryogenic temperature and the control circuit operating at ambient temperature, and enslavement means configured to enslave the operation of the power transistor based on the at least one measurement signal and with respect to a supervised operating parameter.

It is thus advantageously possible to obtain an increased yield of the power transistor due to cryogenic conditions while using standard electronic components for its gate control circuit and to achieve a controlled and enslaved mode of operating of said power transistor with respect to a determined operating condition or parameter, such as the power transistor junction temperature, for instance.

The electronic circuit according to the invention may also include the following characteristics, considered alone or in combination:
- The cryogenic temperature at which the power transistor and the interfacing circuit operate is below -153 ° C.
- The predetermined maximum distance between the location where each of the components of said interfacing circuit is arranged and the power transistor is less than or equal to 1 cm.
- Said control circuit and said interfacing circuit are positioned relative to each other at a distance greater than 10 cm.
- Said interfacing circuit comprises an electronic circuit for protecting said gate, an electronic circuit for stabilizing operating conditions of said gate, and a circuit configured to perform a soft shutdown of said power transistor.
- Said control circuit comprises at least one reconfigurable electronic circuit of the FPGA type configured to deliver a control signal of said gate of said power transistor.
- Said power transistor being of a MOSFET or IGBT or Sic or GaN type.
- Said at least one measurement signal is representative of the junction temperature of the power transistor, the enslavement means being configured to use a correspondence table established during a preliminary characterization and recorded in a memory of said control circuit operating at ambient temperature.
- The electronic circuit comprises measurement means configured to measure multiple measurement signals, and the enslavement means are configured to enslave the operation of the power transistor based on the measurement signals and with respect to a supervised operating parameter.

Another object of the invention is an electronic system comprising at least one electronic circuit as previously described.

According to an embodiment, said power transistor and said interfacing circuit of the electronic system are cooled by a cryogenic fluid.

According to an embodiment, the power transistor of the electronic system comprises a body in which circulates a cryogenic fluid.

According to an embodiment, the power transistor and the interfacing circuit are enveloped in a volume of said cryogenic fluid.

The invention also relates to an aircraft comprising an electronic system as described above or to an electronic component as previously described.

### BRIEF DESCRIPTION OF THE DRAWINGS

The characteristics of the invention mentioned above, as well as others, will appear more clearly on reading the following description of at least one embodiment, said description being made in relation to the attached drawings, among which:
Fig. 1 schematically illustrates an electronic control circuit for controlling a gate of a cryogenic power component;
Fig. 2 schematically illustrates a remote control circuit operating at ambient temperature and being a subset of the electronic circuit already shown in Fig. 1;
Fig. 3 schematically illustrates a close control circuit operating at cryogenic temperature and being another subset of the electronic circuit already shown in Fig. 1; and,
Fig. 4 schematically illustrates an aircraft comprising an electronic control circuit as already shown in Fig. 1.

### DETAILED DESCRIPTION OF AT LEAST ONE EMBODIMENT

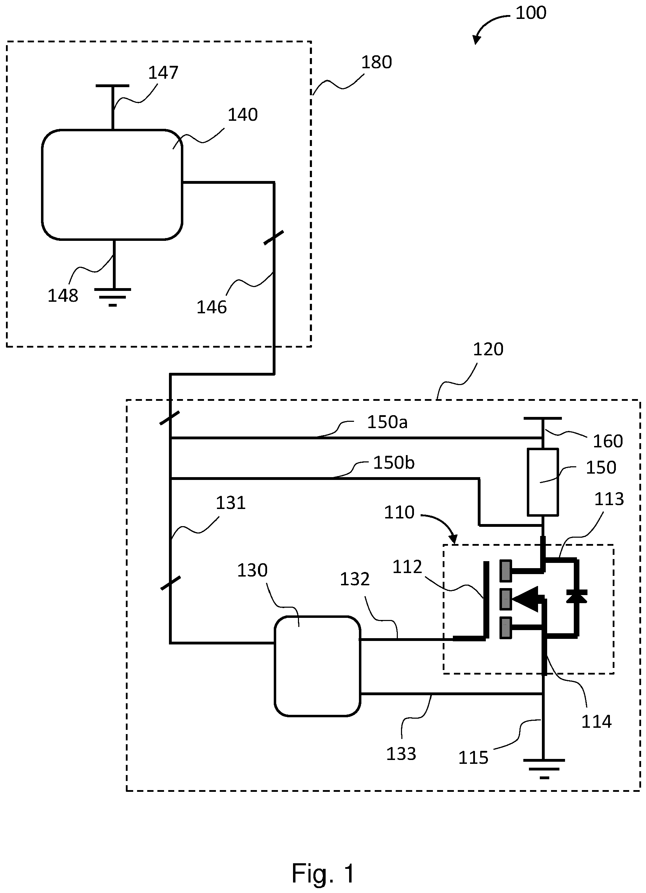

**Fig. 1** schematically illustrates an electronic circuit 100 for controlling current in a load component 150 called "load" hereafter. The load 150 is for example an actuator such as an electric motor. This example is not limiting and the load 150 may be of another type. According to one embodiment, the electronic circuit 100 includes a power transistor 110 of the MOSFET ("Metal Oxide Semiconductor Field-Effect Transistor") type, positioned between a pole of the load 150 and a ground connection 115 of the electronic circuit 100. The power transistor 110 of the MOSFET type includes a drain 113, a source 114 and a gate 112. The source 114 is connected to the ground connection 115. The pole of the load 150 that is connected to the power transistor 110 is connected to the drain 113 of the power transistor 110. The other pole of the load 150 is connected to a power supply line 160 that is able to deliver power through the load 150. The electronic circuit 100 for controlling the current in the load 150 is configured to operate in a saturated-blocked mode, which means that the power transistor 110 is driven as a variable and controlled power resistor allowing to define the intensity of the current flowing through the load 150. To do so, the electronic circuit 100 comprises a control circuit 140 as well as an interfacing circuit 130 of the power transistor 110. The interfacing circuit 130 of the power transistor 110 is an amplification circuit.

The control circuit 140 is powered by a power supply line 147 and is connected to a ground connection 148 of the electronic circuit 100. The interfacing circuit 130 is powered and controlled via an input control bus 131 connected to control and power outputs of the control circuit 140 forming an output control bus 146 of the control circuit 140. The control bus 131 applied at the input of the interfacing circuit 130, connected to the control bus 146 available at the output of the control circuit 140, includes one or more power supply lines useful for operation of the interfacing circuit 130 of the power transistor 110. A gate control output 132 of the interfacing circuit 130 is connected to the gate 112 of the power transistor 110, and a source control output 133 of the interfacing circuit 130 is connected to the source 115 of the power transistor 120 (ground connection).

Astutely, the control circuit 140 is arranged in a space 180 subjected to an ambient temperature and the power transistor 110 as well as its interfacing circuit 130 and the load 150 are arranged in a space 120 subjected to a cryogenic temperature. This advantageously makes it possible to benefit from the so-called cryogenic characteristics for the elements (or components) located in space 120 and to allow the use of standard components for the control circuit 140 arranged in space 180. It is thus possible to combine an increase in the efficiency of the electronic circuit 100 for controlling the current in the load 150, and thus the efficiency of the load 150, with a control of the overall cost of the equipment. Furthermore, for the same weight of equipment, the electrical power in the load 150 can be increased, due to the improved efficiency, which is particularly interesting in the context of a vehicle, and even more so in the context of an aircraft.

The term "cryogenic characteristics" herein refers to characteristics present under the influence of a cryogenic temperature for the components of interest. Thus, for example, since resistivity depends on temperature, a cryogenic characteristic for the load 150 is its advantageously low resistance at cryogenic temperature, due to its low resistivity, which makes it possible to substantially limit the losses by Joule effect for a given operating current.

According to a variant, the load 150 is arranged outside the space 120 subjected to cryogenic temperature and only the power transistor 110 and its interfacing circuit 130 are arranged in the space 120 subjected to cryogenic temperature.

The term "ambient temperature" is used in this description to refer to a temperature between - 153°C and + 80°C. The term "cryogenic temperature" refers to a temperature below -153°C.

Advantageously, and to satisfy the constraints imposed by a cryogenic temperature in the space 120 as well as the constraints due to the MOSFET gate protection requirements, all components of the interfacing circuit 130 are arranged at a distance from the power transistor 110 less than a predetermined threshold distance. According to an embodiment, this predetermined threshold distance is less than or equal to 2 cm and preferably less than or equal to 1 cm. The distance between the interfacing circuit 130 and the power transistor 110 is preferably of few millimeters, for instance between 1 mm and 9 mm, and more preferably between 1 mm and 5 mm.

Thus, the control circuit 140 operates as a remote control circuit and the interfacing circuit 130 operates as a close control circuit with respect to the power transistor 110.

Such an architecture of the electronic circuit 100 advantageously allows operation under a wide range of conditions since the most sensitive part, potentially using integrated circuits, operates under "normal" operating conditions at room temperature, i.e., in a range of temperatures for which its features are precisely specified by the manufacturer, and the parts that are used under unspecified conditions, but benefiting from cryogenic conditions, are preselected during design tests and trials and thus also characterized to achieve good operations.

It is advantageous to only have to characterize the operation of components at cryogenic temperatures for a small number of components.

The distance between the control circuit 140 of the gate control circuit (the "smart" part of the gate control circuit of the transistor 110) and the interfacing circuit 130 can advantageously be several tens of centimeters. For instance, the distance between the control circuit 140 of the gate control circuit and the interfacing circuit 130 is greater than 10 cm, and advantageously greater than 30 centimeters.

The distance between the interfacing circuit 130 itself and the power transistor 110 is a critical parameter because long connections generate additional inductance resulting in a decoupling effect between the interfacing circuit 130 and the transistor gate, and also in unwanted oscillations.

The distance between each of the components of the interfacing circuit 130 and the power transistor 110 must be reduced of the order of only a few millimeters, so as to avoid risks of damage to the power transistor 110, which are increased with the gate loop effect. A maximum distance L between any component of the interfacing circuit and the power transistor 110 is defined for the component layout of the interfacing circuit. According to an embodiment, the distance L is less than or equal to 2 cm and preferably less than 1 cm.

The separation of the electronic circuit 100 into two parts, the intelligent control circuit 140 and the interfacing circuit 130, thus allow very good control of the power transistor 110 by the interfacing circuit 130 calibrated to operate as close as possible to the power transistor 110 and in cryogenic conditions, while allowing the control circuit 140 to operate in normal and well-controlled environmental conditions that do not require prior characterizations.

In addition, some voltage measurements lines 150a and 150b across the load 150 are integrated with the control bus 146 and are connected to the control circuit 140, to enable the control circuit 140 to estimate the current in the load 150. The voltage measurements lines 150a, 150b correspond to measurement means. To this end, the relationship between the voltage across the load and the current through the load is characterized when the load is operating in an environment subject to cryogenic temperatures, and the pairs of currentvoltage values that are thus read are stored in a memory of the control circuit 140. According to one embodiment, the voltage measurement lines 150a and 150b are not connected directly across the load, but across a shunt resistor connected in series with the load 150. In a similar way, the junction temperature of the power transistor 110 is characterized before the operation of the whole set of circuits, so that a determination of the voltage at the terminals of the load 150 (or a shunt resistor serially connected to the load), coupled with other parameters such as, for example, the cryogenic temperature around the power transistor 110, or the gate-source voltage of the power transistor 110, makes it possible to then determine the junction temperature during operation at cryogenic temperature. This advantageously makes it possible to secure the operation of the power transistor by guaranteeing its integrity since it is then possible to control the control parameters of the power transistor according to the estimate made of its junction temperature.

Advantageously, the control circuit 140 of the power transistor 110 comprises a fast analog circuit for detecting a desaturation of the power transistor 110 allowing to detect without delay a combination of operating parameters reflecting an operation of the power transistor 110 outside a valid mode, i.e. with a high risk of combination of drain-source voltage and current likely to lead to a deterioration or even a destruction. According to an embodiment, the desaturation circuit uses digital inputs and/or comparators integrated with an FPGA-type controller circuit of the control circuit 140.

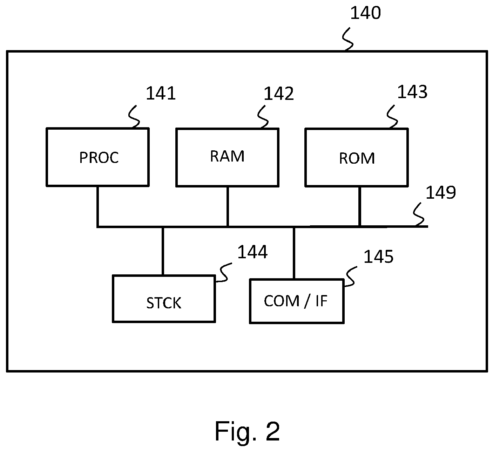

Fig. 2 illustrates an example of the implementation of the control circuit 140 arranged in the space 180 subject to ambient temperature. For illustrative purposes, let us consider that Fig. 2 illustrates an internal arrangement of the control circuit 140 when this circuit is architected in the form of a so-called "intelligent" control circuit, possibly capable of operating under the supervision of an external and remote control unit. According to the example of hardware architecture shown in Fig. 2, the control circuit comprises, connected by a communication bus 149 : a processor or CPU ("Central Processing Unit") 141 ; a RAM ("Random Access Memory") 142 ; a ROM ("Read Only Memory") 143 ; a storage unit such as a hard disk (or a storage media reader, such as an SD ("Secure Digital") card reader 144 ; at least one communication interface 145 allowing to communicate with one or more remote equipment and also offering interfaces such as input/output ports, in particular of a nature to receive and transmit control signals or to control power supply lines.

For example, an input pin of the control circuit 140, connected to an analog-to-digital conversion interface may be also connected to the measurement signal 150b of the circuit shown in Fig. 1 so as to obtain information representative of the voltage across the terminals of the load 150; the electrical potential of the supply line 160 being known, which makes it possible to obtain an estimate of the junction temperature of the power transistor 110, with enslavement means, by means of a correspondence table pre-recorded in a memory of the control circuit 140.

The processor 141 is capable of executing instructions loaded into the RAM 142 from the ROM 143, from an external memory (not shown), from a storage medium (such as an SD card) or attached to a communication network. When the control circuit 140 is powered on, the processor 141 is able to read from the RAM 142 instructions and execute them. These instructions form a computer program causing the processor 141 to implement a portion of a process for controlling the power transistor 110 via the interfacing circuit 130.

All or part of the control process of the transistor 110, implemented by the control circuit 140, or its described variants can be implemented in software form by execution of a set of instructions by a programmable machine, for example a DSP (Digital Signal Processor) or a microcontroller, or be implemented in hardware form by a dedicated machine or component, for example a FPGA (Field-Programmable Gate Array) or an ASIC (Application-Specific Integrated Circuit). In general, the control circuit 140, known as the "intelligent circuit", comprises electronic circuitry configured to implement a process for controlling the power transistor 110, via the interfacing circuit 130. Obviously, the control circuit 140 also includes all the elements usually present in a system comprising a control unit and its peripherals, such as a power supply circuit, a power supply supervision circuit, one or more clock circuits, a reset circuit, input-output ports, interrupt inputs, bus drivers, digital-to-analog and analog-to-digital converters, ideally fast. This list is not exhaustive.

According to an alternative embodiment, the control circuit 140 is configured to control a plurality of power transistors such as, for example, the power transistor 110, via a plurality of interfacing circuits similar to the interfacing circuit 130. Each of the interfacing circuits is then associated with a power transistor arranged in proximity thereto.

According to a preferred embodiment, the control circuit 140 is built around a programmable and reconfigurable FPGA-type circuit, which provides reprogramming capability and provides a good compromise between the ability to configure and adapt to a wide variety of power components and the cost of the control circuit 140.

The control circuit 140 thus configured makes it possible to implement a method for estimating an internal junction temperature of a power component operating at cryogenic temperature via a reading of a representative parameter and after characterization of the component and storage of a table of correspondences. By way of example, such a method could comprise a first step of characterizing the junction temperature as a function of the current and the voltage drop across the transistor (V_{DS}) when the component is turned on, carried out at cryogenic temperature; a second step of storing a correspondence table of junction temperature values and measured current and drain-source voltage values; then a third step of measuring a characteristic representative of the current in the power component, during use of the power component (such as V_{GS} (between gate and source) and/or the current in the load connected thereto) ; followed by a fourth step of determining the junction temperature of the power component by reading the stored correspondence table. The third step is implemented by the measurement means. All this then allowing a fifth step aimed at controlling the power component to adjust its operation in order to guarantee its integrity and the relevance of its mode of operation. The fifth step is implemented by the enslavement means. The power component is controlled based on multiple measurement signals, such as, in a non-limitative way, current or voltage signals, differential voltage between the voltage measurement lines 150a, 150b, the voltage of the voltage measurement line 150b against the ground, the voltage drop across the transistor... A control of the current through the power component 110 could be possible by driving its VGS voltage (between gate and source) when the component is of the MOSFET type, for example, thanks to the control and power lines of the control bus 146, under control of the control circuit 140.

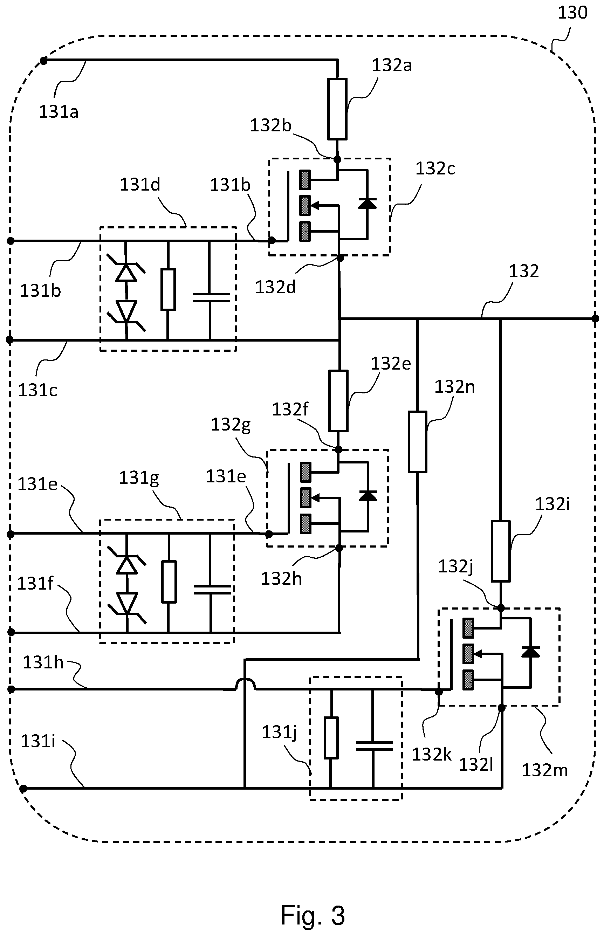

Fig. 3 schematically illustrates an example embodiment of the interfacing circuit 130 driven by the control circuit 140 via the control and power bus 146 connected to the control and power bus 131. The control and power bus 131 includes control or power lines 131a, 131b, 131c, 131e, 131f, 131h and 131i. The purpose of the interfacing circuit 130 is to precisely control the gate drive 132 connected to the gate pin of the MOSFET-type power transistor 110. To do this, the potential of the gate control 132 is defined as a function of the state of two transistors 132c and 132g, also of the MOSFET type, connected in series between the power supply line 131a and the power supply line 131f.More precisely, resistors 132a and 132e are respectively inserted between the supply line 131a and the drain 132b of transistor 132c, on the one hand, and between the source 132d of transistor 132c and the drain 132f of transistor 132g, on the other hand. The gate terminal 132 is connected to the source 132d of transistor 132c. A pull-down resistor 132n is connected between the gate terminal 132 and a ground line 131i of the interfacing circuit 130. The potential of the gate driver 132 is thus driven by the resistors constituted by the MOSFET transistors 132c and 132g. The state of the transistor 132c, operating in saturated-blocked mode, depends on control lines 131b and 131c respectively connected to the gate 131b and to the source 132d of the transistor 132c. Thus, the control lines 131b and 131c make it possible to control the gate-source voltage VGS of the transistor 132c. The current that flows through the transistor 132c between the drain 132b and the source 132d is limited by the gate-source voltage V_{GS} of the transistor 132c and the resistor 132a. In a similar way, the state of the transistor 132g, operating in the saturated-blocked, depends on control lines 131e and 131f respectively connected to the gate 131e and to the source 132h of the transistor 132g. Thus, the control lines 131e and 131f make it possible to control the gate-source voltage VGS of the transistor 132g. The current which passes through the transistor 132g between the drain 132f and the source 132h is limited by the gate-source voltage VGS of the transistor 132g and the resistor 132e. A module 131d for protecting and stabilizing the operating conditions of transistor 132c is connected between gate 131b and source 132d of transistor 132c. Similarly, an operating condition protection and stabilization module 131g for transistor 132g is connected between gate 131e and source 132h of transistor 132g. Each of the operating condition protection and stabilization modules 131d and 131g comprises an assembly of two Zener diodes mounted head-to-tail between the gate and the source to which they are connected, as well as a resistor and a capacitor connected in parallel between the gate and the source to which they are connected. Advantageously, the protection and stabilization of the operating conditions thus effected of transistors 132c and 132g consequently allows protection and stabilization of the operating conditions of power transistor 110, since its gate 112 is connected to gate control 132 and its source 114 is connected to ground 115, which is itself connected to ground connection 131i of interfacing circuit 130, as can be seen in the Figs. A soft shutdown circuit of the gate driver 132, based on a MOSFET 132m, is configured to make a connection of the gate driver 132 to the ground connection 131i depending on the state of a control line 131h connected to the gate 132k of the transistor 132m. In order to limit the current between the drain and the source, a resistor 132i is inserted between the gate driver 132 and the drain 132j of the transistor 132m. The source 1321 of the transistor 132m is connected to the ground connection 131i of the interfacing circuit 130. A module 131j consisting of a resistor and a capacitor connected in parallel between the gate 132k and the source 1321 of the transistor 132m makes it possible to control the evolution of the gate-source voltage VGS of the transistor 132m and thus the driving of the gate control 132 of the transistor 110 in order to operate a "soft shutdown" control of the latter.

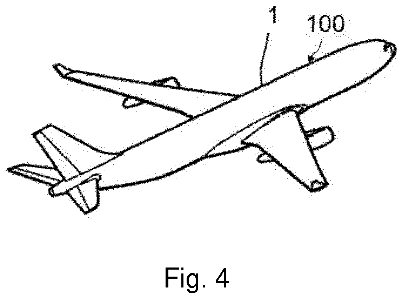

Fig. 4 schematically illustrates an aircraft 1 comprising an electronic current control circuit 100 for controlling a power component as the power transistor 110 operating under cryogenic conditions. Such an electronic circuit is particularly appreciable in aircraft on-board systems comprising cryogenic power components since the use of the latter makes it possible to increase the ratio between the weight of the systems and the power delivered in these systems. For example, the power transistor 110 may be an electronic component capable of controlling a very high current and configured to be cooled, along with its interfacing circuit 130, by means of a cryogenic fluid. According to an example embodiment, the power transistor 110 may be configured such that it comprises a body having one or more conduits through which a cryogenic fluid circulates.

The invention is not limited solely to the described embodiments and example embodiments but more broadly to any electronic circuit configured to drive a power electronic component, wherein the power electronic component and a close interfacing circuit are configured to operate at cryogenic temperature and wherein a remote control circuit connected to the close control circuit is configured to operate at ambient temperature and wherein at least one measurement signal between said interface circuit and command circuit allows to enslave the control of the power electronic component with respect to a determined operating parameter or condition. According to one example, the power component may be a transistor other than a MOSFET, such as an IGBT ("Insulated-Gate Bipolar Transistor"), or a SiC (Silicon Carbide) transistor, or a GaN (Gallium Nitride) transistor.

## Claims

1. Electronic circuit (100) comprising a power transistor (110) comprising a gate (112) connected to a control circuit (140) of said gate (112), the electronic circuit (100) being configured with:
- said control circuit (140) of said gate (112) being configured to operate at a temperature called ambient temperature, non-cryogenic, and,
- said power transistor (110) as well as an interfacing circuit (130) connected between said gate (112) and said control circuit (140) being configured to operate at a cryogenic temperature, each of the components of said interfacing circuit (130) being established at a maximum distance (L) from the power transistor,
**characterized in that** the electronic circuit (100) comprises measurement means configured to measure at least one measurement signal (150b), the measurement means being connected between the interfacing circuit (130) operating at a cryogenic temperature and the control circuit (140) operating at ambient temperature, and enslavement means configured to enslave the operation of the power transistor (110) based on the at least one measurement signal (150b) and with respect to a supervised operating parameter.

2. Electronic circuit (100) according to claim 1, in which the cryogenic temperature is below -153°C.

3. Electronic circuit (100) according to one of claims 1 and 2, wherein said predetermined maximum distance (L) is equal to 1 cm.

4. Electronic circuit (100) according to one of claims 1 to 3, wherein said control circuit (140) and said interfacing circuit (130) are positioned relative to each other at a distance greater than 10 cm.

5. Electronic circuit (100) according to one of claims 1 to 4, wherein said interfacing circuit (130) comprises an electronic circuit for protecting said gate, an electronic circuit for stabilizing operating conditions of said gate and a circuit configured to perform a soft shutdown of said power transistor (110).

6. Electronic circuit (100) according to one of claims 1 to 5, wherein said control circuit (140) comprises at least one reconfigurable electronic circuit (132) of the FPGA type configured to deliver a control signal (134) of said gate (112) of said power transistor (110).

7. Electronic circuit (100) according to one of claims 1 to 6, wherein said power transistor being of a MOSFET or IGBT or SiC or GaN type.

8. Electronic circuit (100) according to one of claims 1 to 7, wherein said at least one measurement signal is representative of the junction temperature of the power transistor (110), the enslavement means being configured to use a correspondence table established during a preliminary characterization and recorded in a memory of the control circuit (140).

9. Electronic circuit (100) according to one of claims 1 to 8, wherein the electronic circuit (100) comprises measurement means configured to measure multiple measurement signals (150b), and wherein the enslavement means are configured to enslave the operation of the power transistor (110) based on the measurement signals (150b) and with respect to a supervised operating parameter.

10. Electronic system comprising at least one electronic circuit (100) according to any one of claims 1 to 9.

11. Electronic system according to claim 10, wherein said power transistor (110) and said interfacing circuit (130) are cooled by a cryogenic fluid.

12. Electronic system according to claim 11, wherein said power transistor (110) comprises a body in which circulates a cryogenic fluid.

13. Electronic system according to claim 11, wherein said power transistor (110) and said interfacing circuit (130) are enveloped in a volume of said cryogenic fluid.

14. Aircraft comprising an electronic system according to one of claims 10 to 13 or an electronic circuit according to one of claims 1 to 9.
